# EUROPEAN PATENT APPLICATION

(11) **EP 4 660 649 A1**
(43) Date of publication of application: **10.12.2025**
(21) Application number: 24180349.3
(22) Date of filing: 06.06.2024
(51) Int. Cl.: G01R 31/385, H01M 10/42, H01M 10/48

(54) **METHOD AND SYSTEM FOR INSPECTION OF ONE OR MORE BATTERY CELLS**

(71) Applicant: LG Energy Solution, Ltd., Seoul 07335 (KR)
(72) Inventor: CHOI, Jin Hyeong, 34122 Daejeon (KR)
(74) Representative: Goddar, Heinz J.

(57) **Abstract**

A method for inspection of one or more battery cells during manufacture, the method comprising: charging the one more battery cells; applying a pressure to the one or more battery cells; and determining whether at least one of the one or more battery cells is faulty based on an electric charging characteristic of the one or more battery cells in reaction to applying the pressure.

## Description

### TECHNICAL FIELD

The present subject relates to a method for inspection of one or more battery cells during manufacture and a system for inspection of one or more battery cells during manufacture.

### BACKGROUND

Battery cells, in particular pouch cells, are manufactured at a sequence of subsequent steps, as illustrated below. Initially, active materials for forming the anode and the cathode of the battery call are mixed. The active material for the cathode is configured to hold lithium ions, such as e.g. an LCO or LMO containing material, and the active material for the anode is configured to receive and store lithium ions, such as a graphite containing material. A slurry of the active materials is coated onto current collectors, i.e. a metal foils usually made of aluminum or copper. Commonly, the active material for the cathode is coated onto an aluminum foil and the active material for an anode is coated onto a copper foil. The current collectors covered with the active materials are roll pressed bounding the active materials to the current collectors. Then, the roll pressed current collectors are cut and notched into pieces to form the electrodes for a battery cell. The electrodes may be uses in cylindrical and prismatic cells or pouch cells.

For the manufacture of a pouch cell laminating and stacking is performed. A first electrode, such as the anode, and a second electrode, such as the cathode, are laminated with a separator using heat and pressure to form mono-cells or bi-cells. The mono-cells or bi-cells are stacked above each other thus forming a sequence in which a first electrode and a second electrodes sandwich a separator. The obtained cells are included in a pouch case. The pouch case is filled with an electrolyte material allowing for an ion exchange between the anode and cathode. After the filling remaining gas is substantially removed by pressing the pouch cell. The pouch cases are sealed to form the pouch cells.

Before the final product is handed out, the obtained pouch cells are "activated". During activation the pouch cells are exposed to a first aging step in which the pouch cells are treated with a preset temperature such as room temperature for a preset period of time, such as 0,5 hours to 3 hours. Then, the pouch cells are charged up to a certain level to prompt decomposition of the electrolyte in the pouch cells. Thereafter, the pouch cells undergo a second aging step in which the pouch cells are exposed to a preset temperature e.g. at about 40-70 °C , wherein potentially evolving gas is in some cases degassed from the pouch cells. The previously described steps are repeated for a couple of times.

After the activation, the pouch cells are electrically functional. At this point the charging capacity of the pouch cells is tested. The testing usually comprises an electrical determination of the charging capacity of the pouch cells. If the tests yield a sufficient charging capacity, the pouch cells are substantially discharged and finally handed out.

Nevertheless, the testing of the pouch cells yields a considerable number of rejects having an insufficient charging capacity after the manufacturing process. This leads to considerable loss for the manufacturer.

### DETAILED DESCRIPTION OF THE INVENTION

### TECHNICAL PROBLEM

It is thus an object of the present disclosure to improve the manufacturing process to the effect that the manufacturing loss for the manufacturing is reduced.

However, the problem to be solved by the embodiments of the present disclosure is not limited to the above-described problem and can be variously expanded within the scope of the technical idea included in the present disclosure.

### TECHNICAL SOLUTION

The objective is solved by the claimed method for inspection of one or more battery cells during manufacture.

The inventors found that when the testing of the battery cells is performed in the conventional manufacturing process, the manufacturer has already invested substantial efforts to fabricate the battery cells and, hence, when the battery cell is found faulty in the conventional manufacturing process, the loss for the manufacturer for each faulty cell is high. The claimed method for inspection of one or more battery cells is has been found reliable and is particularly applicable at an earlier stage during manufacture of the battery cells, preferably before activation of the battery cells. In this manner a method is provided that can reliably detect faulty battery cells which is particularly applicable at an early stage of the manufacturing process such that the loss due to faulty battery cells is reduced.

The method for inspection of one or more battery cells during manufacture, comprises charging the one more battery cells; applying a pressure to the one or more battery cells; and determining whether at least one of the one or more battery cells is faulty based on an electric charging characteristic of the one or more battery cells in reaction to applying the pressure.

The inventors exhibited that applying a pressure to the one or more battery cells mechanically compresses the components of the cells such as the electrodes and the separators. Due to the compression potential leak current paths may form that may lead to a capacity reduction or even dysfunction of the battery product at a later stage. Therefore, if a battery cell forms leaks in reaction to an applied pressure, the battery cell can reasonably be assumed as faulty. Thus, by charging the battery at least up to a predetermined level and determining the electric charging characteristic of the battery cell in reaction to applying the pressure to the battery cells, potentially faulty battery cells can be determined. In result to the determination of faulty battery cells, the cells faulty cells may be discharged from the manufacturing process.

A battery cell may for example be a pouch cell, in particular a pouch cell that has undergone the lamination and stacking prior to the activation or even after the activation.

The electric charging characteristic may for example be a charging voltage or a charging current applied to the one or more battery cells. The charging voltage and/or the charging current may be applied to one or more current collectors of the one or more battery cells. In particular, the charging voltage and/or the charging current may be applied to the current collectors of an anode on the one side and may be applied to the current collectors of a cathode on the other side.

In the following preferred aspects of implementation of the provided method for inspection of one or more battery cells during manufacture are provided.

In one preferable aspect, the charging is performed by applying a constant voltage, and the electric charging characteristic is an electric charging current induced by the constant charging voltage.

In this manner, the applied charging voltage is constant and the induced charging current is variable depending on the resistance of the battery cell. The resistance generally depends on the charging state of the battery cell. Assuming a battery cell without leakage, when applying the constant voltage to the battery cell a charging current is induced in the battery cell, thus increasing the charge in the battery cell. The charging current is initially high. As the amount of charge stored in the battery cell increases, the resistance usually increases, and the charging current saturates when the maximal amount of charge at the constant voltage is reached. However, the resistance may also be influenced by leaks of the battery cell. In the presence of leak current paths, the resistance is usually reduced due to leak currents. Thus, when charging the battery applying a constant voltage, the charging current in reaction to applying a pressure to the one or more battery cells is indicative of potential leakage currents. Therefore, from the behavior of the charging current, when charging the battery cell using a constant voltage, potential leak currents can be determined.

In one preferable aspect, the pressure is applied before charging the one or more battery cells; and determining whether the at least one of the one or more battery cells is faulty comprises determining that the at least one of the one or more battery cells is faulty if the charging current saturates above charging threshold.

Usually assuming a battery cell without leakage, applying a constant charging voltage to the battery cell leads to decrease of the charging current over time until the battery cell saturates. In the saturation regime the battery cell, at given constant voltage, the battery cell is not capable of exchanging ions. The resistance of the battery cell hence increases and the charging current at given constant voltage reduces. Assuming a perfect battery cell without leakage the charging current in the saturation regime reduces to zero or at least below a predetermined threshold.

However, applying a pressure to the battery cell before the charging may induce leakage paths due to the compression of the components. If leakage occurs, the charging current of the battery cell will not drop to zero or at least below the predetermined threshold in the saturation regime. Hence, it can reasonably be assumed that leakage paths occurred if the charging current saturates above a current threshold. Hence, it can reasonably be assumed that the battery cell is faulty or may become faulty. The current threshold may for example be a predetermined valued preferably based on the previous investigation of a plurality of battery cells.

In a further aspect of the method, the pressure is applied when the charging current saturates at a first current value; and determining whether the at least one of the one or more battery cells is faulty comprises determining that the at least one of the one or more battery cells is faulty if the charging current increases above the first current value when the pressure is applied.

In accordance with the above, when applying a constant charging voltage to the one or more battery cells, the charging current decreases to a first current value with the increasing amount of saturation of the one or more battery cells. Applying the pressure when the charging current saturates at the first current value may induce leakage paths. Due to the formation of leakage paths, the charging current may increase above the first current value since the current flow across the leaks. Therefore, when the charging current increases above the first current value in reaction to applying the pressure, it may reasonably be summed that the battery is faulty.

In a further aspect of the method alone or in combination with the previous aspects, the pressure is applied when the charging current saturates at a first current value; and determining that the at least one of the one or more battery cells is faulty if the charging current saturates at a second current value larger than the first current value after applying the pressure and releasing the pressure.

In accordance with the above, when applying a constant voltage, the charging current decreases with the increasing amount of saturation of the battery cell and saturates at the first current value when the battery cell is saturated. Applying a pressure may lead to a formation of leakage paths such that the charging current increases above the first current value. However, when releasing the pressure on the one or more battery cells, the one or more battery cells may expand to the original state as before applying the pressure. If the charging current drops again below a second current value or preferably to the first current value it may be assumed that the leakage paths are reversible, and the battery cells are thus not faulty. However, if the charging current after releasing the pressure saturates above the second current value it may reasonably be assumed that the leakage paths are irreversible, and the battery is faulty. Hence, it can be determined whether at least one of the one or more battery cells is faulty and the one or more battery cells can be discarded form the manufacturing process.

Please note that the constant charging voltage is applied during the entire measurement of the previous aspect, i.e. also during applying a pressure.

In a further aspect of the method, the charging is performed by applying a constant charging current and the electric charging characteristic is an electric charging voltage induced by the constant charging current.

In this manner, the applied charging current is constant and the induced charging voltage across the battery cell is variable depending on the resistance of the battery cell. The resistance generally depends on the charging state of the battery cell. Assuming a battery cell without leakage, when applying the constant current to the battery cell a charging voltage across the battery cell is induced. As the charge of the battery cell increases, the resistance usually increases and the charging voltage increases at constant charging current. However, the resistance may also be influenced by leaks of the battery cell. In the presence of leak current paths, the resistance is usually reduced due to leak currents. In this case the charging voltage drops. Thus, when charging the battery cell by applying a constant current, the charging voltage in reaction to applying a pressure to the one or more battery cells is indicative of potential leakage currents. Therefore, from the behavior of the charging voltage at constant charging current potential leak currents can be determined.

In a further aspect, the pressure is applied before charging the one or more battery cells; and determining whether the at least one of the one or more battery cells is faulty comprises determining that the at least one of the one or more battery cells is faulty if the charging voltage saturates below a charging voltage threshold.

Usually assuming a battery cell without leakage, applying a constant charging current to the battery cell leads to an increase of the charging voltage over time. In the saturation regime of the battery cell, at given constant current, the battery cell is not capable of exchanging ions. The resistance of the battery cell hence increases and the charging voltage at given constant current drastically increases. However, when the charging voltage saturates below the charging voltage threshold, this is an indicator to a finite resistance and thus leak current. Hence, faulty battery cells can be determined.

In a further aspect, the pressure is applied when the charging voltage reaches a first voltage value; and determining whether the at least one of the one or more battery cells is faulty comprises determining that the at least one of the one or more battery cells is faulty, if the charging voltage drops below the first voltage value when the pressure is applied.

In accordance with the above, when applying a constant charging current to the one or more battery cells, the charging voltage increases to a first voltage value with increasing amount of saturation of the one or more battery cells. Applying the pressure when the charging voltage reaches the first voltage value may induce further leakage paths. Due to the formation of leakage paths, the charging voltage may drop below the first voltage value since the resistance drops due to leakage. Therefore, when the charging voltage drops below the first voltage value in reaction to applying the pressure, it may reasonably be summed that the battery is faulty.

In a further aspect alone or in combination with the previous aspect, the pressure is applied when the charging voltage reaches a first voltage value; and determining whether the at least one of the one or more battery cells is faulty comprises determining that the at least one of the one or more battery cells is faulty, if the charging voltage saturates at a second voltage value smaller than the first voltage after the pressure is released.

In accordance with the above, when applying a constant current, the charging voltage increases with increasing amount of saturation of the battery cell. Applying a pressure may lead to a formation of leakage paths such that the charging voltage drops below the first voltage value. However, when releasing the pressure, the one or more battery cells may expand to the original state as before applying the pressure. If the charging voltage increases above the first voltage value after the pressure is released, it may be assumed that the leaks are reversible, and the battery cell is thus not faulty. If the charging voltage saturates at a second voltage value smaller than the first voltage value, i.e. the charging voltage does not increase anymore, it may reasonably be assumed that the leakage path is irreversible, and the battery cells are faulty. Usually, irreversible leakage is an indicator to a faulty battery cell and the respective battery cell my thus be determined as faulty.

Please note that the constant charging voltage is applied during the entire measurement of the previous aspect, i.e. also during applying a pressure.

In a further aspect, wherein the method is performed prior to activating the battery cells. The method can for example be performed after the stacking and laminating. The activation of the one or more battery cells is usually time consuming and energy intensive. Thus, the activation is expensive for the manufacturer. If faulty battery cells are determined prior to the activation of the battery cells, the loss for the manufacturer can be reduced.

In a further aspect, the pressure is applied in a stacking direction of the one or more battery cells. A battery cell may comprise at least a first electrode, a second electrode and a separator. The first electrode, the second electrode and the separator are stacked above each other in a manner that the separator is positioned in between the first electrode and the second electrode. The direction in which the first electrode, the second electrode and the separator are stacked above each other defines the stacking direction. Applying the pressure the stacking direction leads to an even distribution of the pressure across the surface of the one or more battery cells.

In the further aspect, a plurality of battery cells are arranged in parallel, preferably in the stacking direction. Therefore, the pressure applied to the plurality of battery cells evenly distributes across the surfaces of the battery cells and among the battery cells.

In further aspect, each of the plurality of battery cells is separated from another battery cell of the plurality of battery cells by a plate. The plate may for example comprise an even surface. Due to the insertion of a plate in between neighboring battery cells, pressing force acting upon each battery cell is evenly distributed among the battery cells.

In a further aspect, the pressure is applied, preferably in the stacking direction, to the plurality of battery cells on opposing sides of the plurality of battery cells. The plurality of battery cells may for example be piled forming a pile of battery cells. The pressure may be applied to the pile of battery cells on at least one preferably opposing sides for example by pressing plates. In this manner, a plurality of battery cells may be inspected in accordance with the above.

Moreover, the above objective is solved by a system for inspection of one more battery cells, the system comprising: a pressure application device configured to apply a pressure to the one or more battery cells; means configured to charge the one or more battery cells and configured to determine an electric charging characteristic of the one or more battery cells; and a control unit, coupled to the pressure application device and the means, wherein the control unit is configured to determine whether at least one of the one or more battery cells is faulty based on the electric charging characteristic of the one or more battery cells in reaction to the pressure applied to the one or more battery cells.

The control unit is configured to conduct the steps of determining whether at least one of the one or more battery cells is faulty based on an electric charging characteristic of the one or more battery cells in reaction to applying the pressure that have been described in the previous aspects. Thus, the control unit is generally configured to perform all steps of determining whether at least one of the one or more battery cells is faulty as described in the previous aspects of the method for inspection of one or more battery cells.

Even further, the control unit may be configured to issue a signal to the means causing the means to charge the battery cell using either constant voltage or constant current. Furthermore, the control unit may be configured to receive data of the electric charging characteristic from the means. Even further, the control unit may be configured to issue a signal to the pressure application device causing the pressure application device to apply and to release the pressure to the one or more battery cells.

The means may be configured to, in response to a reception of the respective signal from the control unit, apply the constant charging voltage or the constant charging current to the one or more battery cells and determine the respective other charging current or charging voltage on the one or more battery cells. The means are further configured to transmit the respective data to the control unit.

In one aspect, the pressure application device is configured to receive a plurality of battery cells arranged in parallel, preferably in a stacking direction of the plurality of battery cells, wherein optionally the battery cells are separated by plates.

In one aspect, the pressure application device is configured to apply a pressure to the plurality of battery cells on opposing sides.

In accordance with the above, a plurality of battery cells can hence be inspected, while exhibiting an even pressure distribution.

### ADVANTAGEOUS EFFECTS

According to the aspects, potentially faulty battery cells can be reliably determined during manufacture of the battery cells. Furthermore, the manufacturing process can be improved by the described method to the effect that the manufacturing loss for the manufacture is reduced.

The effects of the present disclosure are not limited to the effects mentioned above and additional other effects not described above will be clearly understood from the description of the appended claims by those skilled in the art.

### BRIEF DESCRIPTION OF THE DRAWINGS

FIG. 1 sketches a system for inspection of one or more battery cells during manufacture.
FIG. 2 sketches the charging current when applying a constant voltage according to one aspect.
Fig. 3 sketches the charging current when applying a constant voltage according to one aspect.

### DETAILED DESCRIPTION OF THE EMBODIMENTS

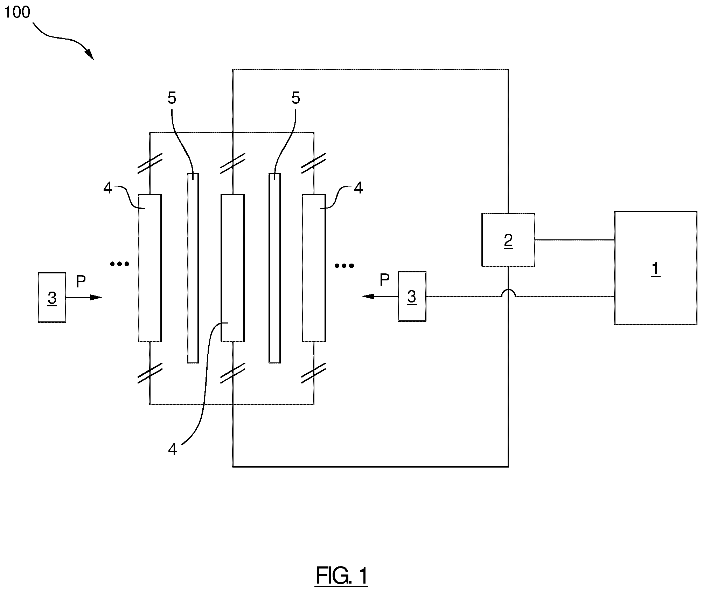

Figure 1 schematically depicts a system 100 for inspection of one or more battery cells 4 during manufacture of the one or more battery cells 4. The system 100 comprises a control unit 1 as well as means 2 for charging the one or more battery cells 4 and for detecting charging characteristics of the one or more battery cells 4. Furthermore, the system 100 comprises a pressure application device 3 configured to apply pressure P to the one or more battery cells 4. The control unit 1 is in communication with the means 2 and the pressure application device 3. The control unit 1 is configured to provide signals to and receive signals from the means 2 and the pressure application device 3.

A battery cell 4 may comprise at least a first electrode, a second electrode and a separator. The first electrode, the second electrode and the separator are stacked above each other in a manner that the separator is positioned in between the first electrode and the second electrode. The direction in which the first electrode, the second electrode and the separator are stacked above each other defines a stacking direction of the battery cell 4. The pressure P is applied to the one or more battery cells 4 in the stacking direction of each of the one or more battery cells 4.

For example, the pressure application device 3 is configured to receive the one or more battery cells 4. In the depicted example, the battery cells 4 are piled in parallel such that the stacking directions of the plurality of battery cells 4 are aligned in parallel preferably coaxial to one another. The battery cells 4 may optionally be separated by plates 5. The pressure application device 3 is configured to apply the pressure P to the plurality of battery cells 4 such that the pressure P acts upon the battery cells 4 in stacking direction.

In some examples the pressure application device 3 may comprise a movable driving plate and a fixed plate configured to receive the one or more battery cells 4 in between. The one or more battery cells 4 are arranged in parallel such that the stacking direction of each of the one or more battery cells 4 is aligned in a pressure application direction. In particular, within the pressure application device 3 the one or more battery cells 4 are aligned so that the stacking direction of each battery cell 4 coincides with the stacking directions of the further battery cells 4. Thus, the stacking direction of each of the one or more battery cells 4 is aligned in the pressure application direction.

The pressure application device may comprise a pressure application shaft coupled to the movable driving plate. The pressure application shaft may further be coupled to operating means of the pressure application device. The operating means are configured to move the driving shaft and the movable driving plate in the pressure application direction. Performing movement in the pressure application direction the movable driving plate presses the one or more battery cells against the fixed plate in the pressure application direction. Therefore, a pressure is applied to the one or more battery cells in stacking direction of each of the one or more battery cells.

In some examples the pressure application device 3 may comprise a fixed pressing plate one the one side of the batter cells 4 and a movable pressing plate on the opposing other side of the battery cells 4. In some examples the pressure application device 3 may comprise two movable fixed pressing plates on opposing sides of the the battery cells 4.

The means 2 are connected to the current collectors of the electrodes of the one or more battery cells 4 via connection lines. The first set of the connection lines connects the means 2 to one or more first electrodes of the one or more battery cells 4. The second set of connection lines connects the means 2 to one or more second electrodes of the one or more battery cells 4. The means 2 are configured to charge the one or more battery cells 4. In particular, the means 2 are configured to apply constant voltage across the first and the second electrodes of the one or more battery cells 4. In some aspects, the means 2 are configured to apply a constant current through the one or more battery cells 4 via the first and the second electrodes. Moreover, the means 2 are configured to detect the charging characteristic of the one or more battery cells 4 when charging the battery cell 4. For example, the means 2 are configured to detect the charging current of the one or more battery cells 4 while applying a constant charging voltage to the one or more battery cells 4. In other examples, the means 2 are configured to detect the charging voltage of the one or more battery cells 4 while applying constant charging current to the one or more battery cells 4. The means 2 may be configured to transmit data corresponding to the determined charging characteristic to the control unit 1.

The control unit 1 is configured to send to the means 2 a signal that causes the means 2 to charge the one or more battery cells 4 and to detect the charging characteristic of the one or more battery cells 4. Furthermore, the control unit 1 is configured to send to the pressure application device 3 a signal that causes the pressure application device 3 to apply a pressure P to the one or more battery cells 4. Furthermore, the control unit 1 is configured to perform the steps of determining whether at least one of the one or more battery cells is faulty based on the electric charging characteristic determined by the means 2 in reaction to the pressure P applied by the pressure application device 3.

In the following, a discussion to the steps of determining whether at least one of the one or more battery cells 4 is faulty will be given according to some aspects.

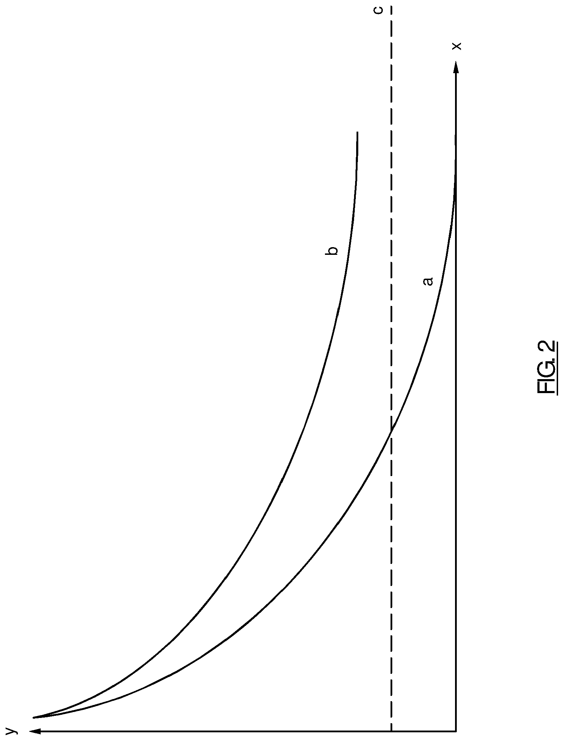

Figure 2 depicts the charging current of the one or more battery cells 4 when applying constant voltage to the one or more battery cells 4. In the aspect depicted in Figure 2 the pressure has been applied to the one or more battery cells 4 prior to the charging. The course of the charging current is depicted in a two-dimensional coordinate system, wherein the y-axis of the coordinate system corresponds to the charging current and the x-axis of the coordinate system corresponds to the time of the charging. The voltage is kept constant during the entire charging process.

Two courses of the charging current are shown in Figure 2. The courses of the charging current are indicated by a and b, wherein course a corresponds to a battery cell without leakage and course b corresponds to a battery cell 4 suffering from leakage after applying the pressure.

In the first course, indicated by a, the charging current is initially high, decreases with the charging time and saturates at zero or at least below a predetermined threshold when the battery cell 4 saturates. Generally, during charging of a battery cell 4, the capability of the battery cell 4 to store charge decreases with increasing amount of charge stored in the battery cell 4. Thus, the resistance of the battery cell decreases during the process of charging the battery cell.

Therefore, at the beginning of the charging process when initially applying the constant charging voltage, the charging current is high. When further charging the battery cell 4, the charging current induced by the constant voltage decreases with the amount of charge stored in the battery cell. Finally, when the battery cell is not capable of storing charge anymore, the charging current saturates.

When the battery cell does not exhibit leaks, as shown in course a, the charging current approaches to zero or at least a constant value below a predetermined threshold. The respective battery cell can then be determined as not faulty.

However, in case of formation of leakage paths due to applied pressure prior to the charging process, as shown in course b, the charging current may saturate at a constant current value above a charging current threshold, c, which is higher than the saturation level as shown in course a. In this case the respective one or more battery cells 4 can be determined as faulty.

If one or more battery cells 4 are determined as faulty the control unit 1 may for example issue a signal, e.g. to a selection unit, that courses discard these one or more battery cells 4, e.g. by the selection unit.

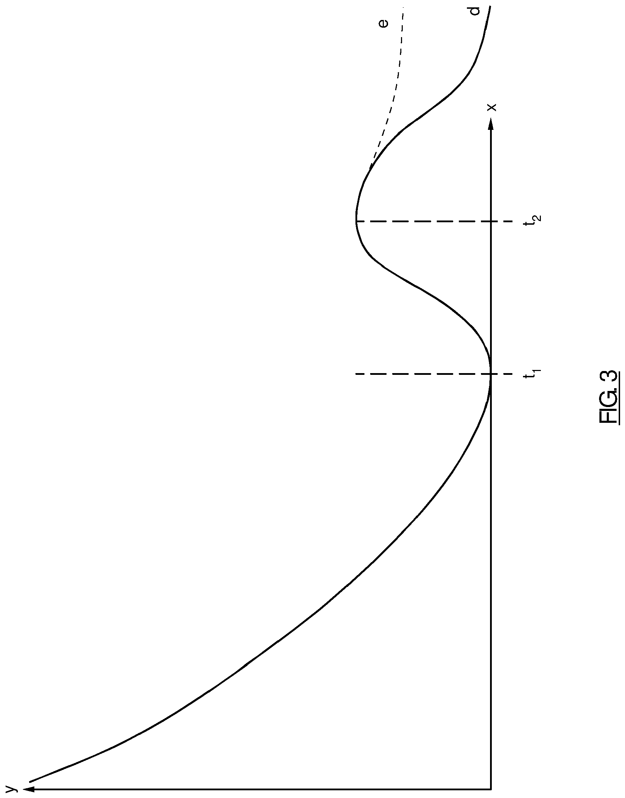

Figure 3 depicts the charging current of the one or more battery cells 4 when applying constant voltage to the one or more battery cells 4. In the aspect depicted in Figure 3 the pressure P is applied to the one or more battery cells 4 during the charging. The course of the charging current is depicted in a two-dimensional coordinate system, wherein the y-axis of the coordinate system corresponds to the charging current and the x-axis of the coordinate system corresponds to the time of the charging. The voltage is kept constant during the entire charging process, i.e. also when applying and preferably when releasing the pressure P.

The course of the charging current is indicated by d. In accordance with the above, at the beginning of the charging process when initially applying the constant charging voltage, the charging current is high. When further charging the battery cell 4, the charging current induced by the constant charging voltage decreases with the amount of charge stored in the battery cell. Finally, when the battery cell is not capable of storing charge anymore, the charging current saturates at a first current value. The first current value may be zero or may at least be below a predefined current threshold.

When the charging current saturates a pressure is applied to the one or more battery cells 4. The time when the pressure is applied in the charging process is indicated by t1. The pressure contracts the components of the one or more battery cells 4. Due to the contraction leakage paths may form in the one or more batter cells 4. If leakage occurs the charging current may raise above the first current value at which the charging current saturated prior to applying the pressure at t1. Due to the increase of the charging current the one ore more battery cells 4 may hence be determined as faulty in some aspects. For example, the control unit 1 may issue a signal that causes rejection of the respective one or more battery cells 4. The signal may for example be issued to a selection unit configured to reject the one or more battery cells 4.

In further aspects, after applying the pressure at t1 the pressure is released at t2. After releasing the pressure, the one or more batterie cells 4 expand.

If the leakage paths are reversible, the charging current my drop until it reaches the first current value as indicated by course (d) in Figure 3. If the charging current drops to the first current value, the one or more battery cells 4 may be determined as non-faulty in some aspects since the formation of leakage paths is reversible.

However, if the leakage paths are not reversible, the charging current may saturate at a constant current value that is larger than the first current value after releasing the pressure. This is indicated by course (e) as shown in Figure 3. In this case, the one or more battery cells 4 can be determined as faulty in some cases. Please note that course (d) and course (e) are substantially the same until t2, when the pressure is released.

For example, the control unit 1 may ussie a signal that causes rejection of the respective one or more battery cells 4. The signal may for example be issued to a selection unit configured to reject the one or more battery cells 4.

### DESCRIPTION OF REFERENCE NUMERALS

- 100: system
- 1: control unit
- 2: means
- 3: pressure application device
- 4: battery cell
- 5: plate

- P: Pressure
- (a)-(e): courses of the charging current
- t1: time when pressure is applied
- t2: time when pressure is released
- x: charging time
- y: charging current

## Claims

1. A method for inspection of one or more battery cells (4) during manufacture, the method comprising:
charging the one more battery cells (4);
applying a pressure (P) to the one or more battery cells (4); and
determining whether at least one of the one or more battery cells (4) is faulty based on an electric charging characteristic of the one or more battery cells (4) in reaction to applying the pressure (P).

2. The method according to claim 1, wherein the charging is performed by applying a constant charging voltage, and wherein the electric charging characteristic is an electric charging current induced by the constant charging voltage.

3. The method according to claim 2, wherein
the pressure (P) is applied before charging the one or more battery cells (4); and
determining whether the at least one of the one or more battery cells (4) is faulty comprises determining that the at least one of the one or more battery cells (4) is faulty if the charging current saturates above a charging current threshold.

4. The method according to claim 2, wherein
the pressure (P) is applied when the charging current saturates at a first current value; and
determining whether the at least one of the one or more battery cells (4) is faulty comprises determining that the at least one of the one or more battery cells (4) is faulty,
if the charging current increases above the first current value when the pressure (P) is applied; and/or
if the charging current saturates at a second current value larger than the first current value after the pressure (P) is released.

5. The method according to claim 1, wherein the charging is performed by applying a constant charging current and the electric charging characteristic is an electric charging voltage induced by the constant charging current.

6. The method according to claim 5, wherein
the pressure (P) is applied before charging the one or more battery cells (4); and
wherein determining whether the at least one of the one or more battery cells (4) is faulty comprises determining that the at least one of the one or more battery cells (4) is faulty if the charging voltage saturates below a charging voltage threshold.

7. The method according to claim 5, wherein
the pressure (P) is applied when the charging voltage reaches a first voltage value; and
determining whether the at least one of the one or more battery cells (4) is faulty comprises determining that the at least one of the one or more battery cells (4) is faulty,
if the charging voltage drops below the first voltage value when the pressure (P) is applied; and/or
if the charging voltage saturates at a second voltage value smaller than the first voltage value after the pressure (P) is released.

8. The method according to anyone of the preceding claims, wherein the method is performed prior to activating the battery cells (4).

9. The method according to claim anyone of the preceding claims, wherein the pressure (P) is applied in a stacking direction of the one or more battery cells (4).

10. The method according to anyone of the preceding claims, wherein a plurality of battery cells (4) are arranged in parallel, preferably in the stacking direction.

11. The method according to claim 10, wherein each of the plurality of battery cells (4) is separated from another battery cell of the plurality of battery cells (4) by a plate.

12. The method according to anyone of claims 10 and 11, wherein the pressure (P) is applied, preferably in the stacking direction, to the plurality of battery cells (4) on opposing sides of the plurality of battery cells (4).

13. A system (100) for inspection of one or more battery cells (4) during manufacture, the system comprising:
a pressure application device (3) configured to apply a pressure (P) to the one or more battery cells (4);
means (2) configured to charge the one or more battery cells (4) and configured to determine an electric charging characteristic of the one or more battery cells (4); and
a control unit (1), coupled to the pressure application device (3) and the means (2), wherein the control unit (1) is configured to determine whether at least one of the one or more battery cells (4) is faulty based on the electric charging characteristic of the one or more battery cells (4) in reaction to the pressure (P) applied to the one or more battery cells (4).

14. The System according to claim 13, wherein the pressure (P) unit is configured to receive a plurality of battery cells (4) arranged in parallel, preferably in a stacking direction of the plurality of battery cells (4), wherein optionally the battery cells (4) are separated by plates (5).

15. The system according claim 14, wherein the pressure (P) unit is configured to apply a pressure (P) to the plurality of battery cells (4) on opposing sides.

## Amended claims

### Amended claims in accordance with Rule 137(2) EPC.

1. A method for inspection of one or more battery cells (4) during manufacture, the method comprising:
charging the one more battery cells (4) by applying a constant charging voltage;
applying a pressure (P) to the one or more battery cells (4) when an electric charging current of the one or more battery cells (4) induced by the constant charging voltage saturates at a first current value; and
determining whether at least one of the one or more battery cells (4) is faulty based on the electric charging current of the one or more battery cells (4) in reaction to applying the pressure (P), the determining comprising
determining that the at least one of the one or more battery cells (4) is faulty,
if the charging current increases above the first current value when the pressure (P) is applied; and/or
if the charging current saturates at a second current value larger than the first current value after the pressure (P) is released.

2. A method for inspection of one or more battery cells (4) during manufacture, the method comprising:
charging the one more battery cells (4) by applying a constant charging current;
applying a pressure (P) to the one or more battery cells (4) when an electric charging voltage of the one or more battery cells (4) induced by the constant charging current reaches a first voltage value; and
determining whether at least one of the one or more battery cells (4) is faulty based on the electric charging voltage of the one or more battery cells (4) in reaction to applying the pressure (P), the determining comprising
determining that the at least one of the one or more battery cells (4) is faulty,
if the electric charging voltage drops below the first voltage value when the pressure (P) is applied; and/or
if the electric charging voltage saturates at a second voltage value smaller than the first voltage value after the pressure (P) is released.

3. The method according to claim 1 or claim 2, wherein the method is performed prior to activating the battery cells (4).

4. The method according to claim anyone of the preceding claims, wherein the pressure (P) is applied in a stacking direction of the one or more battery cells (4).

5. The method according to anyone of the preceding claims, wherein a plurality of battery cells (4) are arranged in parallel, preferably in the stacking direction.

6. The method according to claim 5, wherein each of the plurality of battery cells (4) is separated from another battery cell (4) of the plurality of battery cells (4) by a plate (5).

7. The method according to anyone of claims 5 and 6, wherein the pressure (P) is applied, preferably in the stacking direction, to the plurality of battery cells (4) on opposing sides of the plurality of battery cells (4).

8. A system (100) for inspection of one or more battery cells (4) during manufacture, the system (100) comprising:
a pressure application device (3) configured to apply a pressure (P) to the one or more battery cells (4) when an electric charging current of the one or more battery cells (4) induced by a constant charging voltage saturates at a first current value;
means (2) configured to charge the one or more battery cells (4) by applying the constant charging voltage and configured to determine the electric charging current of the one or more battery cells (4); and
a control unit (1), coupled to the pressure application device (3) and the means (2), wherein the control unit (1) is configured to determine whether at least one of the one or more battery cells (4) is faulty based on the electric charging current of the one or more battery cells (4) in reaction to the pressure (P) applied to the one or more battery cells (4), the control unit (1) further being configured to
determine that the at least one of the one or more battery cells (4) is faulty,
if the charging current increases above the first current value when the pressure (P) is applied; and/or
if the charging current saturates at a second current value larger than the first current value after the pressure (P) is released.

9. A system (100) for inspection of one or more battery cells (4) during manufacture, the system (100) comprising:
a pressure application device (3) configured to apply a pressure (P) to the one or more battery cells (4) when an electric charging voltage of the one or more battery cells (4) induced by a constant charging current reaches a first voltage value; and;
means (2) configured to charge the one or more battery cells (4) by applying the constant charging current and configured to determine the electric charging voltage of the one or more battery cells (4); and
a control unit (1), coupled to the pressure application device (3) and the means (2), wherein the control unit (1) is configured to determine whether at least one of the one or more battery cells (4) is faulty based on the electric charging voltage of the one or more battery cells (4) in reaction to the pressure (P) applied to the one or more battery cells (4), the control unit (1) further being configured to
determine that the at least one of the one or more battery cells (4) is faulty,
if the electric charging voltage drops below the first voltage value when the pressure (P) is applied; and/or
if the electric charging voltage saturates at a second voltage value smaller than the first voltage value after the pressure (P) is released.

10. The System (100) according to claim 8 or claim 9, wherein the pressure (P) unit is configured to receive a plurality of battery cells (4) arranged in parallel, preferably in a stacking direction of the plurality of battery cells (4), wherein optionally the battery cells (4) are separated by plates (5).

11. The system (100) according claim 10, wherein the pressure (P) unit is configured to apply a pressure (P) to the plurality of battery cells (4) on opposing sides.
